# EUROPÄISCHE PATENTSCHRIFT

(11) **EP 4 632 399 B1**
(45) Veröffentlichungstag und Bekanntmachung des Hinweises auf die Patenterteilung: **07.10.2026**
(21) Anmeldenummer: 24169986.7
(22) Anmeldetag: 12.04.2024
(51) Int. Cl.: G01R 31/327, H01H 47/00, H01H 9/16

(54) **BEDIENVORRICHTUNG MIT FUNKTIONSÜBERWACHUNG DER SCHALTZUSTANDSDETEKTION, ZUGEHÖRIGE VERWENDUNG UND VERFAHREN**
OPERATING DEVICE WITH FUNCTION MONITORING OF THE DETECTION OF THE SWITCHING STATE, CORRESPONDING USE AND METHOD
DISPOSITIF DE COMMANDE DOTÉ D'UNE SURVEILLANCE FONCTIONNELLE DE LA DÉTECTION D'ÉTAT DE COMMUTATION, UTILISATION ET PROCÉDÉ ASSOCIÉS

(43) Veröffentlichungstag der Anmeldung: 15.10.2025
(73) Patentinhaber: Preh GmbH, 97616 Bad Neustadt a.d. Saale (DE)
(72) Erfinder: JEGER, Johannes, 97720 Nuedlingen (DE); MÖLTER, Martin, 97616 Bad Neustadt/Lebenhan (DE)
(74) Vertreter: Lohmanns, Bernard

(56) Entgegenhaltungen:
- EP-A2- 1 462 768
- DE-A1- 102017 127 047
- US-A1- 2020 070 662
- US-A1- 2022 203 864

## Beschreibung

Die Erfindung bezieht sich auf eine Bedienvorrichtung, die ein durch einen Bediener bedienbares Schaltelement, wie einen Schalter oder Taster, und einen ersten Mikrocontroller zur Ermittlung des jeweiligen Schaltzustands des Schaltelements aufweist. Diese Mikrocontroller weisen typischerweise einen analog-nach-digital wandelnden oder einen digitalen Eingang auf, um anhand des an dem Eingang anliegenden Potenzials auf den Schaltzustand des Schaltelements zu schließen. In der ISO 26262 ist je nachdem, wie sicherheitsrelevant, die durch die Bedienvorrichtung zusteuernde Fahrzeugfunktion ausfällt, der technische Aufwand festgelegt, mit dem die Funktionssicherheit der Bedienvorrichtung ("funktionelle Sicherheit") gewährleistet werden kann. Dies betrifft beispielswiese den zu verwendeten Mikrocontroller. Dieser Mikrocontroller ist vergleichsweise teuer und aufwändig in der Konstruktion, insbesondere wenn er mehrere Eingänge, beispielsweise zur Ermittlung der Schaltzustände mehrerer Schaltelemente aufweist, und ist gegebenenfalls bei krisenbedingtem Mangel schwierig zu beschaffen. Das Festsitzen im Erfassungsbereich ist ein bekannter Fehlermodus von Mikrocontrollern in einem Kraftfahrzeug. Andere Fehler betreffen die Probleme, dass Werte außerhalb des Erfassungsbereichs, niedrige Werte außerhalb des Erfassungsbereichs und ein Versatz zwischen dem tatsächlichen Wert (Nennwert) und dem gemessenen Wert vorliegt. Ein Mikrokontroller, der im Erfassungsbereich festsitzt, ist derart ausgefallen, dass er ein konstantes Signal erzeugt, das innerhalb des normalen Erfassungsbereichs liegt, dies ist besonders problematisch und schwierig zu detektieren. Eine herkömmliche Plausibilitätsdiagnose, sieht vor die gemessenen Werte eines ersten Mikrocontrollers aufgrund eines ersten Signals mit den gemessenen Werten eines zweiten Mikrocontrollers aufgrund eines zweiten Signals, wobei das erste und zweite Signal korrelierte Signale sind, zu vergleichen, um festzustellen, ob einer der ersten und zweiten Mikrokontroller im Erfassungsbereich festsitzt, indem die absolute Differenz zwischen den Signalen mit einer Fehlergrenze verglichen wird. Wenn die absolute Differenz zu groß ist, wird mindestens eines der gemessenen Werte so aufgefasst, dass der zugehörige Mikrocontroller im Erfassungsbereich festsitzt und fehlerhaft ist. In der Praxis wird die Fehlergrenze für diesen Typ von Plausibilitätsdiagnose ziemlich hoch eingestellt, um fälschliche Anzeigen eines Fehlers durch die Diagnose zu minimieren. Folglich ist dieser Typ von Plausibilitätsdiagnose auf das Diagnostizieren von Mikrocontrollern beschränkt, die einen erheblichen Versatzbetrag aufweisen, oder diejenigen, die im Erfassungsbereich bei einem Wert weit entfernt vom Nennwert festsitzen, so dass dieser Typ von Plausibilitätsdiagnose einen Detektionsbereich aufweist, der ähnlich wie eine Diagnose außerhalb des Erfassungsbereichs ist und in der Empfindlichkeit auf diejenige dieser Diagnose begrenzt ist.

DE 102017127047 A1 beschreibt ein in einem Fahrzeug eingebautes Schaltungserfassungssystem.

Vor diesem Hintergrund bestand Bedarf nach einer Bedienvorrichtung, bei der eine Funktionsüberwachung zuverlässig gewährkleistet ist, insbesondere das Feststecken des Mikrocontrollers im Erfassungsbereich zuverlässig detektiert werden kann, sowie eine ISO 26262 konforme Funktionsüberwachung, vergleichsweise einfach und damit kostengünstig realisiert werden kann. Diese Aufgabe wird durch eine Bedienvorrichtung des Anspruch 1 gelöst. Eine gleichermaßen vorteilhafte Verwendung sowie ein Verfahren zur Funktionsüberwachung ist jeweils Gegenstand der nebengeordneten Ansprüche. Vorteilhafte Ausgestaltungen sind Gegenstand der jeweils abhängigen Ansprüche. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft eine Bedienvorrichtung, die einen ersten Mikrocontroller mit wenigstens einem ersten Messeingang, der zur Erfassung eines jeweils am ersten Messeingang anliegenden Messpotentials und Ausgabe eines jeweilig zugehörigen, von dem jeweiligen Messpotenzial abhängigen Detektionsergebnisses ausgebildet ist. Erfindungsgemäß ist ferner eine Spannungsquelle mit einer durch zwei Versorgungspotenziale vorgegebenen Versorgungsspannung vorgesehen.

Die erfindungsgemäße Vorrichtung weist ferner ein mit der Versorgungsspannung beaufschlagtes Widerstandnetzwerk auf, wobei der erste Messeingang des ersten Mikrocontrollers mit einem ersten Abgriff am Widerstandsnetzwerk elektrisch leitend verbunden ist.

Erfindungsgemäß ist mindestens ein in dem Widerstandnetzwerk integriertes Schaltelement vorgesehen, dessen Schaltzustand aus mindestens zwei Schaltzuständen durch Bedienen, Berühren und/oder Betätigen, eines Bedieners von einem Schaltzustand in den jeweils anderen Schaltzustand gewechselt wird. Beispielsweise handelt es sich bei dem Schaltelement, um einen elektromechanischen Schalter oder Taster, oder einen kapazitiv- oder resistivsensorisches Schaltelement.

Erfindungsgemäß ist das Widerstandsnetzwerk so ausgebildet ist, dass dem jeweiligen Schaltzustand ein anderes, an dem ersten Messeingang anliegendes Schaltpotenzial zugeordnet ist, wobei bevorzugt sich wenigstens ein Schaltpotenzial von den Versorgungspotenzialen unterscheidet, bevorzugter sich alle Schaltpotenziale von den Versorgungspotenzialen unterscheiden.

Erfindungsgemäß ist ferner ein dem ersten Mikrocontroller übergeordneter, zweiter Mikrocontroller vorgesehen, der ausgebildet ist, das jeweilige Detektionsergebnis des ersten Mikrocontrollers zu empfangen und an eine übergeordnete Steuereinheit auszugeben. Übergeordnet meint, dass der zweite Mikrocontroller auf dem Weg der Datenübermittlung des Detektionsergebnisses vom ersten Mikrocontroller zur Steuereinheit nicht nur zwischengeschaltet ist, sondern über die Weitergabe an die Steuereinheit in Abhängigkeit einer von ihm getriggerten Funktionsüberprüfung entscheidet.

Dazu ist erfindungsgemäß ein vom ersten Mikrocontroller und/oder vom zweiten Mikrocontroller steuerbares, in das Widerstandsnetzwerk integriertes, aktives Bauelement vorgesehen, das so angesteuert wird, beispielsweise durch Beeinflussung des Widerstandsnetzwerks, dass als am ersten Messeingang anliegendes Messpotenzial ein Störpotenzial mit einem vorgegebenen zeitlichen Verlauf anliegt. Beispielsweise ist das aktive Bauelement ein elektromechanischer Schalter oder ein halbleiterbasiertes Schaltelement, wie ein Transistor. Beispielsweise wird durch das aktive Bauelement ein zusätzlicher Zweig im Widerstandsnetzwerk geschaltet. Der vorgegebene zeitlich Verlauf, meint beispielsweise den betragsmäßigen zeitlichen Verlauf, bevorzugt ist zumindest die Frequenz des zeitlichen Verlaufs des Störpotenzial vorgegeben. Beispielsweise ist der vorgegebene zeitliche Verlauf des Störpotenzials im ersten Mikrocontroller oder im zweiten Mikrocontroller als Vorgabe hinterlegt. Je nach dem wo die Vorgabe hinterlegt ist, im ersten oder zweiten Mikrocontroller, kann der Vergleich des Detektionsergebnisses des ersten Mikrocontrollers mit der Vorgabe erfolgen. In einer Ausgestaltung ist die den zeitlichen Verlauf des Störpotenzials betreffende Vorgabe im zweiten Mikrocontroller hinterlegt, wird lediglich an den ersten Mikrocontroller zur Ansteuerung des aktiven Bauelements übermittelt, während der nachfolgende Vergleich des sich aus der Ansteuerung ergebenden Detektionsergebnisses nach Übermittlung an den zweiten Mikrocontroller übermittelt wird, um von diesem durch Vergleich der beiden bei nicht-hinreichender Übereinstimmung eine Nicht-Detektion des zeitlichen Verlaufs des Störpotenzials und damit eine Fehlfunktion des ersten Mikrocontrollers anzunehmen.

Erfindungsgemäß ist der zweite Mikrokontroller ausgebildet, im Falle einer Nicht-Detektion des vorgegebenen zeitlichen Verlaufs des Störpotenzials durch den ersten Mikrocontroller während der zugehörigen Ansteuerung des aktiven Bauelements und damit unter Annahme einer Fehlfunktion des ersten Mikrocontrollers eine nachfolgende Ausgabe des Detektionsergebnis an die übergeordnete Steuereinheit zumindest vorübergehend zu unterdrücken. Durch die erfindungsgemäße Auslegung lässt sich eine Fehlfunktion des ersten Mikrocontrollers, aber insbesondere dessen Festsitzen im Erfassungsbereich zuverlässig detektieren, insbesondere kann eine mikrocontroller-basierte Detektion leicht durch eine einfache Erweiterung mit einer übergeordneten Überprüfung durch einen weiteren Mikrocontroller in eine ISO 26262 konforme Auslegung überführt werden.

Bevorzugt ist der vorgegebene Verlauf des Störpotenzials periodisch und weist eine Frequenz auf, die höher ist als eine minimale Schaltfrequenz des Schaltelements.

Bevorzugt ist wenigstens der erste Messeingang des ersten Mikrokontrollers als Digitaleingang ausgebildet.

Um die Störempfindlichkeit gegenüber elektromagnetischer Einstreuung zu erhöhen, weist der erste Mikrocontroller gemäß einer bevorzugten Ausgestaltung einen zweiten Messeingang auf, der mit einem sich vom ersten Abgriff unterscheidenden, zweiten Abgriff im Widerstandnetzwerk elektrisch leitend verbunden ist und ausgebildet ist, das Detektionsergebnis aus einem Potenzialunterschied zwischen dem am ersten Messeingang und zweiten Messeingang jeweils anliegenden Messpotenzial zu bestimmen. Bevorzugter ist der zweite Messeingang und der erste Messeingang als Digitaleingang ausgebildet. Beispielsweise erfolgt der erste und zweite Abgriff an jeweils einem anderen Zweig des Widerstandsnetzwerks.

Bevorzugt sind zwei Schaltelemente vorgesehen, deren Schaltzustände aus mindestens zwei Schaltzuständen durch Betätigen eines Bedieners gewechselt werden, wobei die Schaltelemente in unterschiedlichen Zweigen des Widerstandsnetzwerks integriert sind.

Bevorzugt ist pro Schaltelement ein aktives Bauelement vorgesehen, wobei die aktiven Bauelemente parallel angesteuert werden.

Bevorzugt ist vorgesehen, dass, während das Störpotenzial mit dem vorgegebenen, zeitlichen Verlauf am ersten Messeingang des ersten Mikrocontrollers anliegt, das erste Schaltelement in einem geöffneten Zustand ist, d.h. der zugehörige Zweig des Widerstandsnetzwerks unterbrochen ist. Bevorzugter ist vorgesehen, dass, während das Störpotenzial mit dem vorgegebenen, zeitlichen Verlauf am ersten Messeingang und am zweiten Messeingang des ersten Mikrocontrollers anliegt, das erste und zweite Schaltelement in einem geöffneten Zustand sind, d.h. die zugehörigen Zweige des Widerstandsnetzwerks unterbrochen sind.

Bevorzugt ist der zweite Mikrocontroller ausgebildet, einen Störfall an die übergeordnete Steuereinheit zu melden.

Die Erfindung betrifft ferner die Verwendung der Bedienvorrichtung in einer der zuvor beschriebenen Ausführungsformen in einem Kraftfahrzeug zur Funktionsüberwachung einer sicherheitsrelevanten Schaltzustandsdetektion.

Die Erfindung betrifft ferner ein Verfahren zur Funktionsüberwachung einer Schaltzustandsdetektion mit den folgenden Schritten. In einem Bereitstellungsschritt wird eine Bedienvorrichtung in einer der zuvor beschriebenen Ausführungsformen bereitgestellt. In einem Ansteuerschritt des erfindungsgemäßen Verfahrens erfolgt ein Ansteuern des aktiven Bauelements derart, dass als am ersten Messeingang anliegendes Messpotenzial ein Störpotenzial mit einem vorgegebenen, zeitlichen Verlauf anliegt. In einem gleichzeitigen oder nachfolgenden Schritt werden erfindungsgemäß die ansonsten vorgesehene Ausgabe und Übermittlung des Detektionsergebnisses von dem zweiten Mikrocontroller an eine übergeordnete Steuereinheit für den Fall ausgesetzt, dass vorher das Störpotenzial während der durch den zweiten Mikrokontroller bewirkten Ansteuerung des aktiven Bauelements von dem ersten Mikrokontroller nicht detektiert wurde. Dadurch lässt sich eine Fehlfunktion des Mikrocontrollers, aber insbesondere dessen Festsitzen im Erfassungsbereich zuverlässig detektieren.

Andere vorteilhafte Ziele, Nutzen und Umsetzungen dieser Erfindung gehen aus der detaillierten Beschreibung eines konkreten Ausführungsbeispiels in Verbindung mit der beigelegten Zeichnung deutlicher hervor, in welcher:

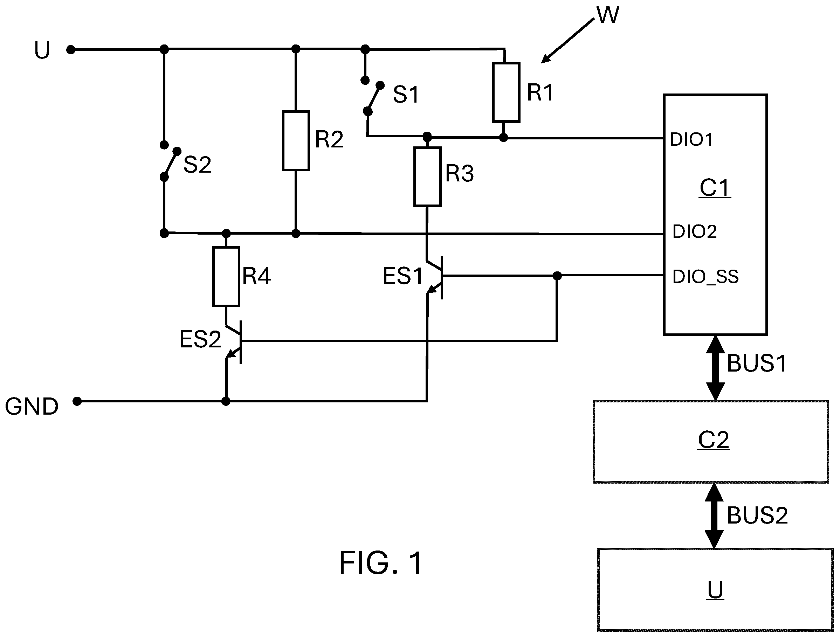

- Fig. 1: ein Ausführungsbeispiel eines elektronischen Schaltplans der Vorrichtung gemäß dieser Erfindung darstellt.

Die Erfindung betrifft eine Bedienvorrichtung 1, die einen ersten Mikrocontroller C1 mit einem Digitaleingang als ersten Messeingang DIO1 und einem weiteren Digitaleingang als zweiten Messeingang DIO2 aufweist, die jeweils zur Erfassung eines jeweils am ersten Messeingang DIO1 bzw. zweiten Messeingang DIO2 anliegenden Messpotentials und Ausgabe eines jeweilig zugehörigen, von dem jeweiligen Messpotenzial abhängiges Detektionsergebnis ausgebildet sind. Es ist ferner eine Spannungsquelle mit einer durch zwei Versorgungspotenziale U und GND vorgegebenen Versorgungsspannung vorgesehen. Mit der aus den Versorgungspotenzialen U und GND gebildeten Versorgungsspannung wird ein Widerstandnetzwerk W beaufschlagt.

Der erste Messeingang DIO1 des ersten Mikrocontrollers C1 ist mit einem ersten Abgriff A1 des Widerstandsnetzwerks W elektrisch leitend verbunden, während ein zweiter Abgriff A2 des Widerstandnetzwerks W elektrisch leitend mit dem zweiten Messeingang DIO2 des ersten Mikrokontrollers C1 verbunden ist. Das Widerstandsnetzwerk W umfasst zwei zwischen den Versorgungspotenzialen U, GND parallel verschaltete Stromzweige mit jeweils in dem Stromzweig integrierte Schaltelemente S1 und S2. Deren Schaltzustand aus mindestens zwei Schaltzuständen wechselt durch Bedienen, Berühren und/oder Betätigen, eines Bedieners von einem Schaltzustand in den jeweils anderen Schaltzustand. Hier ist beispielsweise der unbetätigte Zustand der jeweils geöffnete Zustand des Schaltelement S1 und S2. Beispielsweise handelt es sich bei dem ersten Schaltelement S1 und zweiten Schaltelement S2, jeweils um einen elektromechanischen Schalter oder Taster. Das Widerstandsnetzwerk W ist so ausgebildet, dass dem jeweiligen Schaltzustand des ersten und zweiten Schaltelements S1 S2 ein anderes Schaltpotenzial, zumindest pro Messeingang zugeordnet ist. In geschlossenem Schaltzustand des ersten Schaltelements S1 wird der Widerstand R1 überbrückt und der erste Messeingang DIO1 auf das Versorgungspotenzial U als erstes Messpotenzial gelegt, während im geöffneten Schaltzustand des ersten Schaltelements S1 das um die am Widerstand R1 abfallende Spannung reduzierte Versorgungspotenzial U als erstes Messpotenzial am ersten Messeingang DIO1 anliegt. In geschlossenem Schaltzustand des zweiten Schaltelements S2 wird der Widerstand R2 überbrückt und der zweite Messeingang DIO2 auf das Versorgungspotenzial U als zweites Messpotenzial gelegt, während im geöffneten Schaltzustand des zweiten Schaltelements S2 das um die am Widerstand R2 abfallende Spannung reduzierte Versorgungspotenzial U als zweites Messpotenzial am zweiten Messeingang DIO2 anliegt. Damit liegt am ersten Messeingang DIO1 bzw. zweiten Messeingang DIO2 jeweils das vom Schaltzustand der Schaltelemente S1, S2 abhängige Schaltpotenzial an.

Der erste Mikrocontroller C1 ist ausgebildet, die an dem ersten Messeingang DIO1 bzw. zweiten Messeingang DIO2 anliegenden Schaltpotenziale als Bedieneingabe des ersten Schaltelements S1 beziehungsweise des zweiten Schaltelements S2 zu detektieren und über einen ersten Datenbus BUS1 an einen übergeordneten Mikrocontroller C2 zu übermitteln.

Der dem ersten Mikrocontroller C1 übergeordnete, zweite Mikrocontroller C2 ist vorgesehen und ausgebildet, das jeweilige Detektionsergebnis des ersten Mikrocontrollers C1 zu empfangen und an eine übergeordnete Steuereinheit U über einen zweiten Datenbus BUS2 auszugeben. Übergeordnet meint, dass der zweite Mikrocontroller C2 auf dem Weg der Datenübermittlung des Detektionsergebnisses vom ersten Mikrocontroller C1 zur übergeordneten Steuereinheit U nicht nur zwischengeschaltet ist, sondern über die Weitergabe an die übergeordnete Steuereinheit U in Abhängigkeit einer von ihm getriggerten Funktionsüberprüfung entscheidet.

Dazu sind zwei vom ersten Mikrocontroller C1 über eine Ansteuerleitung DIO_SS steuerbare, in das Widerstandsnetzwerk W integrierte, aktive Bauelement ES1 und ES2 vorgesehen, um einerseits das am ersten Messeingang DIO1 und am zweiten Messeingang DIO2 anliegende Messpotenzial jeweils auf ein, bevorzugt sich durch den jeweiligen Spannungsabfall an den Widerständen R3 bzw. R4 von allen Schaltpotenzialen unterscheidendes, Störpotenzial mit vorgegebenem zeitlichen Verlauf zu legen, indem eine leitende Verbindung des Abgriffs A1 und des Abgriffs A2 über R3 und R4 mit den Versorgungspotenzial GND hergestellt wird, während die Schaltelemente S1 und S2 sich jeweils im geöffneten Zustand befinden. Der zeitliche Verlauf dieses Störpotenzials ist periodisch und weist eine Frequenz auf die höher ist als eine minimale, durch händische Betätigung der Schaltelemente S1 und S2 erreichbare Schaltfrequenz. Hier sind die aktiven Bauelemente ES1 und ES2 jeweils ein halbleiterbasiertes Schaltelement, wie ein Transistor. Das Störpotenzial kann dabei für den ersten Messeingang DIO1 und den zweiten Messeingang DIO2 je nach Wahl der Widerstände R3 bzw. R4 betragsmäßig gleich oder unterschiedlich sein. Die den zeitlichen Verlauf des Störpotenzials betreffende Vorgabe ist im zweiten Mikrocontroller C2 hinterlegt, und wird lediglich an den ersten Mikrocontroller C1 zur Ansteuerung der aktiven Bauelemente ES1 und ES2 übermittelt, während der nachfolgende Vergleich des sich aus der Ansteuerung ergebenden Detektionsergebnisses nach Übermittlung an den zweiten Mikrocontroller C2 übermittelt wird, um von diesem durch Vergleich der beiden bei nicht-hinreichender Übereinstimmung eine Nicht-Detektion des zeitlichen Verlaufs des Störpotenzials und damit eine Fehlfunktion des ersten Mikrocontrollers C1 anzunehmen.

Der zweite Mikrokontroller C2 ist ausgebildet, im Falle, dass das Detektionsergebnis des ersten Mikrocontrollers C1 während der Ansteuerung der aktiven Bauelemente ES1 und ES2 nicht dem vorgegebenen zeitlichen Verlauf des Störpotenzials, beispielsweise dessen Frequenz innerhalb vorgegebener Toleranzgrenzen, entspricht, eine nachfolgende Ausgabe des Detektionsergebnis an die übergeordnete Steuereinheit U zumindest vorübergehende zu unterdrücken. Durch die erfindungsgemäße Auslegung lässt sich eine Fehlfunktion des ersten Mikrocontrollers C1, aber insbesondere dessen Festsitzen im Erfassungsbereich zuverlässig detektieren.

## Patentansprüche

1. Bedienvorrichtung (1), aufweisend:
einen ersten Mikrocontroller (C1) mit wenigstens einem ersten Messeingang (DIO1), der zur Erfassung eines jeweils am ersten Messeingang (DIO1) anliegenden Messpotentials und Ausgabe eines jeweilig zugehörigen, von dem jeweiligen Messpotenzial abhängigen Detektionsergebnisses ausgebildet ist;
eine Spannungsquelle mit einer durch zwei Versorgungspotenziale (U, GND) vorgegebenen Versorgungsspannung;
ein mit der Versorgungsspannung beaufschlagtes Widerstandnetzwerk (W), wobei der erste Messeingang (DIO1) mit einem ersten Abgriff (A1) am Widerstandsnetzwerk (W) elektrisch leitend verbunden ist;
mindestens ein in dem Widerstandnetzwerk (W) integriertes Schaltelement (S1, S2), dessen Schaltzustand aus mindestens zwei Schaltzuständen durch Bedienen eines Bedieners gewechselt wird; wobei das Widerstandsnetzwerk (W) so ausgebildet ist, dass dem jeweiligen Schaltzustand ein anderes, am ersten Messeingang (DIO1) anliegendes Schaltpotenzial zugeordnet ist, wobei bevorzugt sich wenigstens ein Schaltpotenzial von den Versorgungspotenzialen (U, GND) unterscheidet;
ein dem ersten Mikrocontroller (C1) übergeordneter, zweiter Mikrocontroller (C2), der ausgebildet ist, das jeweilige Detektionsergebnis des ersten Mikrocontrollers (C1) zu empfangen und an eine übergeordnete Steuereinheit (U) auszugeben;
wenigstens ein vom ersten Mikrocontroller (C1) und/oder zweiten Mikrocontroller (C2) steuerbares, in das Widerstandsnetzwerk (W) integriertes, aktives Bauelement (ES1, ES2), das so angesteuert wird, dass als am ersten Messeingang (DIO1) anliegendes Messpotenzial ein Störpotenzial mit einem vorgegebenen, zeitlichen Verlauf anliegt;
wobei der zweite Mikrokontroller (C2) ausgebildet ist, im Falle, dass das Detektionsergebnis des ersten Mikrocontrollers (C1) während der Ansteuerung des wenigstens einen aktiven Bauelements (ES1, ES2) nicht dem vorgegebenen zeitlichen Verlauf des Störpotenzials entspricht, eine nachfolgende Ausgabe des Detektionsergebnis an die übergeordnete Steuereinheit (U) zumindest vorübergehend zu unterdrücken.

2. Bedienvorrichtung (1) nach Anspruch 1, wobei der vorgegebene Verlauf des Störpotenzials periodisch ist, und eine Frequenz aufweist, die höher ist als eine minimale Schaltfrequenz des Schaltelements (S1, S2).

3. Bedienvorrichtung (1) nach einem der vorhergehenden Ansprüche, wobei wenigstens der erste Messeingang (DIO1) des ersten Mikrokontrollers (C1) als Digitaleingang ausgebildet ist.

4. Bedienvorrichtung (1) nach einem der vorhergehenden Ansprüche, wobei der erste Mikrocontroller (C1) einen zweiten Messeingang (DIO2) aufweist, der mit einem sich vom ersten Abgriff (A1) unterscheidenden, zweiten Abgriff (A2) im Widerstandnetzwerk (W) elektrisch leitend verbunden ist und ausgebildet ist, das Detektionsergebnis aus einem Potenzialunterschied zwischen dem am ersten Messeingang (DIO1) und zweiten Messeingang (DIO2) jeweils anliegenden Messpotenzial zu bestimmen.

5. Bedienvorrichtung (1) nach einem der vorhergehenden Ansprüche, aufweisend zwei Schaltelemente (S1, S2), deren Schaltzustände aus mindestens zwei Schaltzuständen durch Betätigen eines Bedieners gewechselt werden und die Schaltelemente (S1, S2) in unterschiedlichen Zweigen des Widerstandsnetzwerks (W) integriert sind.

6. Bedienvorrichtung (1) nach dem vorhergehenden Anspruch, wobei pro Schaltelement (S1, S2) ein aktives Bauelement (ES1, ES2) vorgesehen ist, wobei die aktiven Bauelemente (ES1, ES2) parallel angesteuert werden.

7. Bedienvorrichtung (1) nach einem der vorhergehenden Ansprüche, wobei das wenigstens eine aktive Bauelement (ES1, ES2) ein halbleiterbasiertes Schaltelement ist.

8. Bedienvorrichtung (1) nach einem der vorhergehenden Ansprüche, wobei während das Störpotenzial mit dem vorgegebenen, zeitlichen Verlauf am ersten Messeingang (DIO1) des ersten Mikrocontrollers (C1) anliegt, das erste Schaltelement (S1) in einem geöffneten Zustand ist.

9. Bedienvorrichtung (1) nach einem der vorhergehenden Ansprüche, wobei der zweite Mikrocontroller (C2) ausgebildet ist, einen Störfall an die übergeordnete Steuereinheit (U) zu melden.

10. Verwendung der Bedienvorrichtung (1) gemäß einem der vorhergehenden Ansprüche in einem Kraftfahrzeug zur Funktionsüberwachung einer sicherheitsrelevanten Schaltzustandsdetektion.

11. Verfahren zur Funktionsüberwachung einer Schaltzustandsdetektion mit den folgenden Schritten:
Bereitstellen einer Bedienvorrichtung (1) gemäß einem der vorhergehenden Ansprüche 1 bis 8;
Ansteuern des aktiven Bauelements (ES) derart, dass als am ersten Messeingang (DIO1) anliegendes Messpotenzial ein Störpotenzial mit einem vorgegebenen, zeitlichen Verlauf anliegt;
Unterdrücken einer Ausgabe des Detektionsergebnisses von dem zweiten Mikrocontroller (C2) an die übergeordnete Steuereinheit (U) für den Fall, dass das Detektionsergebnis des ersten Mikrocontrollers (C1) während der durch den ersten Mikrocontroller (C1) und/oder zweiten Mikrocontroller (C2) bewirkten Ansteuerung des aktiven Bauelements (ES1, ES2) von dem ersten Mikrokontroller (C1) nicht dem vorgegebenen Verlauf des Störpotenzials entspricht.

## Claims

1. Operating device (1), comprising:
a first microcontroller (C1) having at least one first measurement input (DIO1), which is configured to sense a measurement potential respectively present at the first measurement input (DIO1) and to output a respectively associated detection result dependent on the respective measurement potential;
a voltage source having a supply voltage predetermined by two supply potentials (U, GND);
a resistor network (W) to which the supply voltage is applied, wherein the first measurement input (DIO1) is electrically conductively connected to a first tap (A1) at the resistor network (W);
at least one switching element (S1, S2) integrated in the resistor network (W), whose switching state is changed from among at least two switching states by operating of an operator; wherein the resistor network (W) is configured such that a different switching potential, present at the first measurement input (DIO1), is assigned to the respective switching state,
wherein preferably at least one switching potential differs from the supply potentials (U, GND);
a second microcontroller (C2) superordinate to the first microcontroller (C1), which is configured to receive the respective detection result of the first microcontroller (C1) and to output it to a superordinate control unit (U);
at least one active component (ES1, ES2), controllable by the first microcontroller (C1) and/or second microcontroller (C2) and integrated in the resistor network (W), which is driven such that an interference potential with a predetermined temporal profile is present as the measurement potential present at the first measurement input (DIO1);
wherein the second microcontroller (C2) is configured, in the event that the detection result of the first microcontroller (C1) during the driving of the at least one active component (ES1, ES2) does not correspond to the predetermined temporal profile of the interference potential, to suppress a subsequent output of the detection result to the superordinate control unit (U) at least temporarily.

2. Operating device (1) according to claim 1, wherein the predetermined profile of the interference potential is periodic and has a frequency that is higher than a minimum switching frequency of the switching element (S1, S2).

3. Operating device (1) according to one of the preceding claims, wherein at least the first measurement input (DIO1) of the first microcontroller (C1) is configured as a digital input.

4. Operating device (1) according to one of the preceding claims, wherein the first microcontroller (C1) has a second measurement input (DIO2), which is electrically conductively connected to a second tap (A2) in the resistor network (W) differing from the first tap (A1) and is configured to determine the detection result from a potential difference between the measurement potential respectively present at the first measurement input (DIO1) and second measurement input (DIO2).

5. Operating device (1) according to one of the preceding claims, comprising two switching elements (S1, S2), whose switching states are changed from among at least two switching states by actuating of an operator, and the switching elements (S1, S2) are integrated in different branches of the resistor network (W).

6. Operating device (1) according to the preceding claim, wherein one active component (ES1, ES2) is provided per switching element (S1, S2), wherein the active components (ES1, ES2) are driven in parallel.

7. Operating device (1) according to one of the preceding claims, wherein the at least one active component (ES1, ES2) is a semiconductor-based switching element.

8. Operating device (1) according to one of the preceding claims, wherein, while the interference potential with the predetermined temporal profile is present at the first measurement input (DIO1) of the first microcontroller (C1), the first switching element (S1) is in an open state.

9. Operating device (1) according to one of the preceding claims, wherein the second microcontroller (C2) is configured to report a fault condition to the superordinate control unit (U).

10. Use of the operating device (1) according to one of the preceding claims in a motor vehicle for function monitoring of a safety-relevant switching-state detection.

11. Method for function monitoring of a switching-state detection, comprising the following steps:
providing an operating device (1) according to one of the preceding claims 1 to 8;
driving the active component (ES) such that an interference potential with a predetermined temporal profile is present as the measurement potential present at the first measurement input (DIO1);
suppressing an output of the detection result from the second microcontroller (C2) to the superordinate control unit (U) in the event that the detection result of the first microcontroller (C1), during the driving of the active component (ES1, ES2) effected by the first microcontroller (C1) and/or second microcontroller (C2), on the part of the first microcontroller (C1) does not correspond to the predetermined profile of the interference potential.

## Revendications

1. Dispositif de commande (1), comprenant :
un premier microcontrôleur (C1) présentant au moins une première entrée de mesure (DIO1), qui est conçue pour détecter un potentiel de mesure présent respectivement à la première entrée de mesure (DIO1) et pour délivrer un résultat de détection respectivement associé, dépendant du potentiel de mesure respectif ;
une source de tension présentant une tension d'alimentation prédéfinie par deux potentiels d'alimentation (U, GND) ;
un réseau de résistances (W) auquel la tension d'alimentation est appliquée, la première entrée de mesure (DIO1) étant reliée de manière électriquement conductrice à une première prise (A1) au réseau de résistances (W) ;
au moins un élément de commutation (S1, S2) intégré dans le réseau de résistances (W), dont l'état de commutation est changé parmi au moins deux états de commutation par actionnement de commande d'un opérateur ; le réseau de résistances (W) étant conçu de telle sorte qu'un potentiel de commutation différent, présent à la première entrée de mesure (DIO1), soit associé à l'état de commutation respectif, au moins un potentiel de commutation se distinguant de préférence des potentiels d'alimentation (U, GND) ;
un deuxième microcontrôleur (C2) hiérarchiquement supérieur au premier microcontrôleur (C1), qui est conçu pour recevoir le résultat de détection respectif du premier microcontrôleur (C1) et pour le délivrer à une unité de commande hiérarchiquement supérieure (U) ;
au moins un composant actif (ES1, ES2), pilotable par le premier microcontrôleur (C1) et/ou le deuxième microcontrôleur (C2) et intégré dans le réseau de résistances (W), qui est piloté de telle sorte qu'un potentiel de perturbation présentant une évolution temporelle prédéfinie soit présent en tant que potentiel de mesure présent à la première entrée de mesure (DIO1) ;
le deuxième microcontrôleur (C2) étant conçu, dans le cas où le résultat de détection du premier microcontrôleur (C1) pendant le pilotage de l'au moins un composant actif (ES1, ES2) ne correspond pas à l'évolution temporelle prédéfinie du potentiel de perturbation, pour supprimer au moins temporairement une délivrance ultérieure du résultat de détection à l'unité de commande hiérarchiquement supérieure (U).

2. Dispositif de commande (1) selon la revendication 1, dans lequel l'évolution prédéfinie du potentiel de perturbation est périodique et présente une fréquence qui est supérieure à une fréquence de commutation minimale de l'élément de commutation (S1, S2).

3. Dispositif de commande (1) selon l'une des revendications précédentes, dans lequel au moins la première entrée de mesure (DIO1) du premier microcontrôleur (C1) est conçue en tant qu'entrée numérique.

4. Dispositif de commande (1) selon l'une des revendications précédentes, dans lequel le premier microcontrôleur (C1) présente une deuxième entrée de mesure (DIO2), qui est reliée de manière électriquement conductrice à une deuxième prise (A2) dans le réseau de résistances (W) se distinguant de la première prise (A1) et qui est conçue pour déterminer le résultat de détection à partir d'une différence de potentiel entre le potentiel de mesure présent respectivement à la première entrée de mesure (DIO1) et à la deuxième entrée de mesure (DIO2).

5. Dispositif de commande (1) selon l'une des revendications précédentes, comprenant deux éléments de commutation (S1, S2), dont les états de commutation sont changés parmi au moins deux états de commutation par actionnement d'un opérateur, et les éléments de commutation (S1, S2) sont intégrés dans des branches différentes du réseau de résistances (W).

6. Dispositif de commande (1) selon la revendication précédente, dans lequel un composant actif (ES1, ES2) est prévu par élément de commutation (S1, S2), les composants actifs (ES1, ES2) étant pilotés en parallèle.

7. Dispositif de commande (1) selon l'une des revendications précédentes, dans lequel l'au moins un composant actif (ES1, ES2) est un élément de commutation à base de semi-conducteur.

8. Dispositif de commande (1) selon l'une des revendications précédentes, dans lequel, pendant que le potentiel de perturbation présentant l'évolution temporelle prédéfinie est présent à la première entrée de mesure (DIO1) du premier microcontrôleur (C1), le premier élément de commutation (S1) est dans un état ouvert.

9. Dispositif de commande (1) selon l'une des revendications précédentes, dans lequel le deuxième microcontrôleur (C2) est conçu pour signaler un incident à l'unité de commande hiérarchiquement supérieure (U).

10. Utilisation du dispositif de commande (1) selon l'une des revendications précédentes dans un véhicule automobile pour la surveillance de fonctionnement d'une détection d'état de commutation pertinente pour la sécurité.

11. Procédé de surveillance de fonctionnement d'une détection d'état de commutation, comprenant les étapes suivantes :
fournir un dispositif de commande (1) selon l'une des revendications précédentes 1 à 8 ;
piloter le composant actif (ES) de telle sorte qu'un potentiel de perturbation présentant une évolution temporelle prédéfinie soit présent en tant que potentiel de mesure présent à la première entrée de mesure (DIO1) ;
supprimer une délivrance du résultat de détection du deuxième microcontrôleur (C2) à l'unité de commande hiérarchiquement supérieure (U) dans le cas où le résultat de détection du premier microcontrôleur (C1),
pendant le pilotage du composant actif (ES1, ES2) effectué par le premier microcontrôleur (C1) et/ou le deuxième microcontrôleur (C2), de la part du premier microcontrôleur (C1) ne correspond pas à l'évolution prédéfinie du potentiel de perturbation.
